## Europäisches Patentamt

(19) **European Patent Office**

**Office européen des brevets**

(11) Publication number: **0 053 513**
**B1**

(12) **EUROPEAN PATENT SPECIFICATION**

(45) Date of publication of patent specification: **28.10.87**

(51) Int. Cl.⁴: **H 01 L 31/10**

(21) Application number: **81305658.7**

(22) Date of filing: **01.12.81**

(54) **Avalanche photodiodes.**

(30) Priority: **02.12.80 JP 169889/80**

(43) Date of publication of application:
**09.06.82 Bulletin 82/23**

(45) Publication of the grant of the patent:
**28.10.87 Bulletin 87/44**

(84) Designated Contracting States:
**DE FR GB**

(56) References cited:

**ELECTRONICS LETTERS, vol. 16, no. 18,
August 1980, pages 716-717, Hitchin Herts
(GB); F.OSAKA et al.: "InP/InGaAsP avalanche
photodiodes with new guard ring structure"**

**IEEE TRANSACTIONS ON ELECTRON
DEVICES, vol. ED-26, no. 11, November 1979,
page 1846, no. TP-C15, New York (USA);
J.P.DONNELLY et al.: "Guarded avalanche
photodiodes in InP fabricated by a double Ion
Implantation technique"**

(73) Proprietor: **FUJITSU LIMITED**
**1015, Kamikodanaka Nakahara-ku
Kawasaki-shi Kanagawa 211 (JP)**

(72) Inventor: **Osaka, Fukunobu**
**979, Kawawa-cho Midori-ku
Yokohama-shi Kanagawa 226 (JP)**
Inventor: **Shirai, Tatsunori**
**2-1, Fujigaoka Midori-ku
Yokohama-shi Kanagawa 227 (JP)**

(74) Representative: **Sunderland, James Harry et al
HASELTINE LAKE & CO Hazlitt House 28
Southampton Buildings Chancery Lane
London WC2A 1AT (GB)**

(56) References cited:
**APPLIED PHYSICS LETTERS, vol. 35, no. 3,
August 1979, pages 251-253, New York (USA);
K.NISHIDA et al.: "InGaAsP heterostructure
avalanche photodiodes with high avalanche
gain"**

Courier Press, Leamington Spa, England.

(58) References cited:

**ELECTRONICS LETTERS, vol. 15, no. 5, July 1979, pages 453-455, Hitchin Herts (GB); K.TAGUCHI et al.:InP-InGaAsp planar avalanche photodiodes with self-guard-ring effect"**

**ELECTRONICS LETTERS, vol. 17, no. 22, October 1981, pages 826-827, London (GB); T.SHIRAI et al.: "1.3 um InP/InGaAsP planar avalanche photodiodes"**

## Description

The present invention relates to avalanche photodiodes (hereinafter referred to as APD's).

An APD is a type of photodiode which can offer various performance advantages, such as higher grade avalanche gain, sensitivity and response time and lower values of dark-current and noise, as compared with other types. These advantages arise from an avalanche breakdown phenomenon which occurs at a p-n junction which is arranged in a multiplication layer in the APD which has a reverse bias applied thereto when the APD is in use to cause the avalanche multiplication of a current of electrons and/or holes generated in a light absorbing region of the device which is exposed to receive light arriving at that region.

For such advantages to be realised, it must be provided that avalanche breakdown occurs exclusively and uniformly in a central region of the diode where light is absorbed. Therefore, APD's require some means effective to limit breakdown to a central region of the above mentioned p-n junction.

The wavelength of light to which an APD is sensitive is determined by the band gap Eg of the material of which the light absorbing layer of the APD is made. In order to produce an APD sensitive to longer wavelength light, a combination of layers of semiconductor, one of which has a relatively small band gap Eg and functions as a light absorbing layer and the other of which has a relatively large band gap Eg and functions as a multiplication layer, is convenient. For the production of an APD sensitive to light in the wavelength range 1.2 to 1.65 micrometers, a combination of

$$In_xGa_{1-x}As_{1-y}P_y$$

and InP, or a combination of GaSb and $Ga_xAl_{1-x}Sb$ is preferably employed.

Multilayered APD's employing the above mentioned group III—V compound or alloy semiconductors have been proposed which have a so-called self guard ring layer configuration, in which a p-n junction is formed for the purpose of avalanche multiplication slightly above the heterojunction between the light absorbing layer, of

$$In_xGa_{1-x}As, \ In_xGa_{1-x}As_{1-y}P_y$$

or the like, and the multiplication layer, of InP or the like, whereby the intensity of electric field in the light absorbing layer is larger in the central region of the diode, or in a light absorbing region, than in other regions thereof, or in regions not exposed to light, causing the breakdown voltage of the p-n junction to become less in the central region of the diode which is exposed to light than in regions which are not exposed to light. This provides the guard ring effect. The function of this so-called self guard ring configuration is based upon the characteristic that the band gap Eg of the group III—V compound or alloy semiconductor of which the light absorbing layer is made is less than the band gap Eg of the group III—V compound or alloy semiconductor of which the multiplication or active layer is made and that the breakdown voltage is less for the former than for the latter. It has been determined that this so-called self guard ring configuration provides an excellent guard ring effect.

Electronics Letters, Vol. 16, No. 18, August 1980, pages 716 to 717, discloses an InP/InGaAsP avalanche photodiode with a guard ring structure. To form the photodiode a lattice matched n-InGaAsP layer is grown on a $N^+$-InP substrate, with two n-InP layers grown on the n-InGaAsP layer, by liquid phase epitaxy. The donor concentration of the upper n-InP layer is designed to be higher than those of the lower n-InP and n-InGaAsP layers. The upper n-InP layer is etched off except for an active region, than a $p^-$-InP layer is formed on the active region and the lower n-InP layer. A guard ring effect is provided because the active region p-n junction is formed with the more heavily doped upper n-InP layer (the active region).

The inventors of the present invention have, however, discovered that APD's having the so-called self guard ring configuration have a drawback as described below.

Since the intensity of electric field is necessarily high in the light absorbing layer, a tunnel current or a current component resulting from carriers directly excited by the high intensity of electric field has inevitably occurred in the light absorbing layer, giving rise to various adverse effects, e.g. relatively large amounts of dark current, noise or the like. It is well-known that the magnitude of tunnel effect is larger for a substance having a lesser band gap Eg, such as group III—V compound or alloy semiconductors, e.g.

$$In_xGa_{1-x}As_{1-y}P_y$$

or GaSb and the like.

Since, it is well-known that the fundamental absorption edge is determined by the equality $\lambda = hc/Eg$, and in view of the fact that the signal transmission loss in an optical fibre is less for longer wavelength light it is therefore preferable in fibre optics communications to use APD's sensitive to longer wavelength light, having thus a light absorbing layer made of a material having a lesser band gap Eg.

For this reason, the above-described drawback arising from the relatively large amount of tunnel current which is inherent in APD's having the so-called self guard ring configuration is of serious practical significance.

The present invention is concerned with the provision of APD's which do not suffer from the above-mentioned drawback. Embodiments of the present invention can also afford various other advantages.

The present invention provides a multilayer APD having a guard ring configuration which can readily realise an efficient guard ring effect without suffering the above-described tunnel current problem, as a result providing for the realisation of

higher grades of avalanche-gain, sensitivity and response time and lower values of dark-current and noise.

The present invention provides for an APD of a planar type.

For example, the present invention can provide an APD sensitive to light in a wavelength range 1.2 to 1.65 micrometers, which is provided with a light absorbing layer made of a group III—V compound or alloy semiconductor, for example

$$In_xGa_{1-x}As_{1-y}P_y$$

or GaSb, and with a multiplication or active layer made of another group III—V alloy or compound semiconductor, for example InP or $Ga_xAl_{1-x}Sb$, having a larger band gap Eg than that of the material of the light absorbing layer.

This invention can further provide a planar type APD having a more efficient guard ring effect, realising a more pronounced difference in breakdown voltage between the central region of the p-n junction and other regions thereof.

This invention can also provide a planar type APD having a simple layer configuration, in which the number of essential design parameters is reduced from three to two, thereby allowing considerable freedom for design and production of the APD.

This invention has an embodiment which provides an APD having

(a) a light absorbing layer made of a group III—V compound or alloy semiconductor, such as

$$In_xGa_{1-x}As_yP_{1-y},$$

GaSb, or the like, containing one or some impurities of one conductivity type preferably in a relatively low concentration,

(b) a middle layer, which is relatively thin, for example of a thickness of 0.5 micrometers or less, made of a material which allows lattice matching between itself and the light absorbing layer and which has a larger band gap Eg than that of the semiconductor forming the light absorbing layer, preferably a group III—V compound or alloy semiconductor, such as InP where the light absorbing layer is of

$$In_xGa_{1-x}As_{1-y}P_y$$

or $Ga_xAl_{1-x}Sb$ where the light absorbing layer is of GaSb, containing one or some impurities of a conductivity type the same as that of the light absorbing layer preferably in a concentration the same as or greater than that of the light absorbing layer, the middle layer being grown on the light absorbing layer, and

(c) a multiplication or active layer, of a relatively large thickness, for example 4 to 5 micrometers, of a material which allows lattice matching between itself and the middle layer and which has a larger band gap Eg than that of the semiconductor forming the light absorbing layer, preferably a group III—V compound or alloy semiconductor substantially identical to that of the middle layer, primarily containing one or some impurities of a conductivity type the same as that of the middle layer in a concentration which is less than, e.g. several tenths of, that of the middle layer, the active layer being grown on the middle layer,

the active layer having therein a light sensitive region which contains one or some impurities of a conductivity type different from that of the impurities of the middle layer in a high concentration, e.g. approximately $10^{18}/cm^3$, that light sensitive region being separated from other regions of the active layer by a p-n junction having gradually inclined sides surrounding the light sensitive region.

The position of the p-n junction (e.g. the flat bottom of the p-n junction, in the light sensitive region) is in the neighbourhood of the interface between the middle layer and the active layer.

Such an APD embodying the present invention has the following attributes:—

1. The breakdown voltage is higher for the gradually inclined sides of the p-n junction that for the flat bottom of the p-n junction, as a result allowing preferential breakdown for the region exposed to light (the light sensitive region) when the device is in use. As a result, an effective guard ring effect is provided.
2. The middle layer, containing impurities in a relatively high concentration (for example as compared with the active layer), considerably decreases the intensity of electric field in the light absorbing layer, as a result decreasing the magnitude of tunnel current to a value which is insignificant in comparison with the other components of dark-current.
3. The relatively low magnitude of impurity concentration contained in the active layer (for example as compared with the middle layer) decreases the intensity of electric field, even at a time when a breakdown occurs, as a result increasing the ratio of ionisation coefficient of electrons and holes.
4. The APD is of the planar type.

It is noted that the above proposed configuration of an embodiment of the present invention has become possible because the inventors of this invention have discovered that a InP epitaxial layer containing n-impurity in a concentration as low as $1 \times 10^{15}/cm^3$ can be grown by employing an unintentional doping liquid phase epitaxial process concurrently accompanied by compensation for p-type impurities.

This invention has a second embodiment which is an APD having:—

(a) a light absorbing layer, which may be formed as described above with connection with the first embodiment of this invention,

(b) a middle layer, which may be formed as described above for the first embodiment of this invention, and

(c) an active layer, which may be formed substantially as described above for the first embodiment of this invention, but having a relatively deep region therein, forming the light sensitive region, which contains one or some impurities of a conductivity type different from that of the light absorbing, middle and active layers, in a high concentration, e.g. approximately $10^{18}$/cm$^3$, and the active layer also having a relatively shallow region, forming a guard ring surrounding the light sensitive region, which contains one or some impurities of conductivity type the same as that of the light sensitive region in a high concentration the same as that of the light sensitive region, the light sensitive region and the guard ring region being separated from other regions of the active layer by a p-n junction which is stepped, having a relatively deep part in relation to the light sensitive region, and a relatively shallow part in relation to the guard region, with an abrupt transition between the deep and shallow parts. The p-n junction may have abruptly vertical sides which surround the light sensitive region and join together the junction in respect of the light sensitive region and the junction in respect of the shallow flat guard ring region.

Such an APD has the attribute that a more pronounced difference in breakdown voltages between the light sensitive region and the guard ring region is achieved, resulting in a more reliable guard ring effect.

It will be understood that the ranges of layer thicknesses above are indicated only by way of example. Devices embodying the present invention may be constructed with layer thicknesses different from those mentioned above, as will be seen from the descriptions below in which reference is made to the drawings. Values of impurity concentration mentioned above are likewise by way of example only.

Reference is made, by way of example, to the accompanying drawings, in which:—

Figures 1 to 5 are respective sectional views for assistance in explanation of the structure of an APD embodying the present invention, the respective Figures showing the APD at various stages in its production, Figure 5 showing the finished APD.

Figure 6 is a graph illustrating electric field intensity versus distance from a p-n junction formed in the light sensitive region of a APD having a layer configuration as illustrated in Figure 5,

Figure 7 is a graph showing electric field intensity versus distance from a p-n junction in a guard ring region of an APD having a layer configuration as shown in Figure 5,

Figure 8 is a schematic sectional view illustrating the layer configuration of an APD in accordance with another embodiment of the present invention, and

Figure 9 is a graph illustrating breakdown voltage versus horizontal position in an APD having a layer configuration as shown in Figure 8.

Two broad embodiments of the present invention are presented above. An APD in accordance with the second broad embodiment as mentioned above will be described first herebelow, followed by a description of an APD in accordance with the first broad embodiment.

For simplicity, the descriptions given herebelow of APD's in accordance with the first and second broad embodiments of this invention will be provided in relation to APD's having an n-InP substrate, an n-InP buffer, an

$$n\text{-}In_xGa_{1-x}As_yP_{1-y}$$

light absorbing layer, an n-InP middle layer, and an n-InP active layer, a limited, deep, region of the active layer being doped with a p-type impurity to form a light sensitive region which is surrounded by a shallow p-doped region forming a guard ring. Production of the layers of the APD's will be assumed to be effected by continuously growing the layers employing liquid phase epitaxy in one process. Of course, lattice matching is required between adjacent layers.

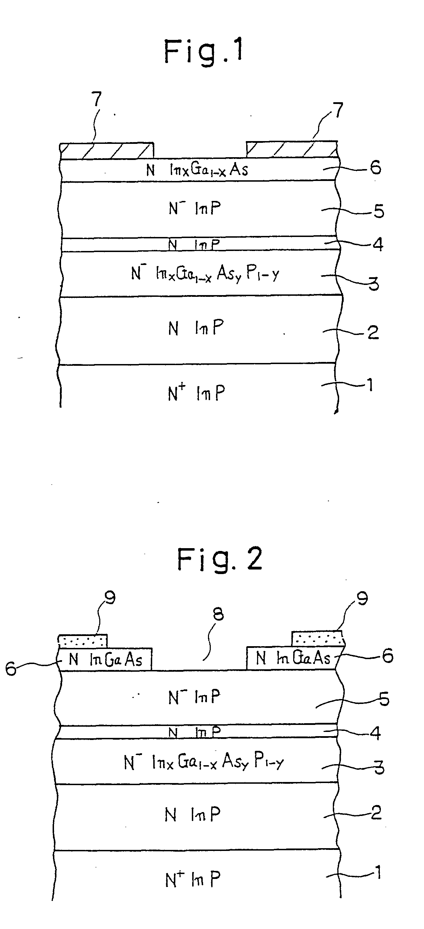

Referring to Figure 1, a first step in the production of an APD in accordance with the second general embodiment of the present invention, is the growth of an n-InP buffer layer 2 of a thickness of several micrometers and an n-impurity concentration of approximately $10^{16}$/cm$^3$ on an n-InP single crystal substrate 1 with an n-impurity concentration of approximately $10^{18}$/cm$^3$. The purpose of this step is simply to provide improved crystal conditions or surface conditions, and this step is not essential to the present invention but preferable. Technical significance of the above-mentioned values of impurity concentration and layer thickness are merely exemplary.

A second step is to grow a $n\text{-}In_xGa_{1-x}As_yP_{1-y}$ light absorbing layer 3 of a thickness of 2 micrometers or more with an n-impurity concentration of $5\times10^{15}$ to $1\times10^{16}$/cm$^3$ on the substrate 1, or preferably on the buffer layer 2.

A third step is to grow an n-InP middle layer 4 of a thickness of 0.5 micrometers or less with an n-impurity concentrations the same as or greater than that of the light absorbing layer 3, possibly more than $2\times10^{16}$/cm$^3$, on the light absorbing layer 3.

A fourth step is to grow an n-InP active layer 5 of a thickness of approximately 2.5 micrometers and with an n-impurity concentration which is tenths of that of the middle layer, or less, preferable $5\times10^{15}$ to $1\times10^{16}$/cm$^3$, on the middle layer 4.

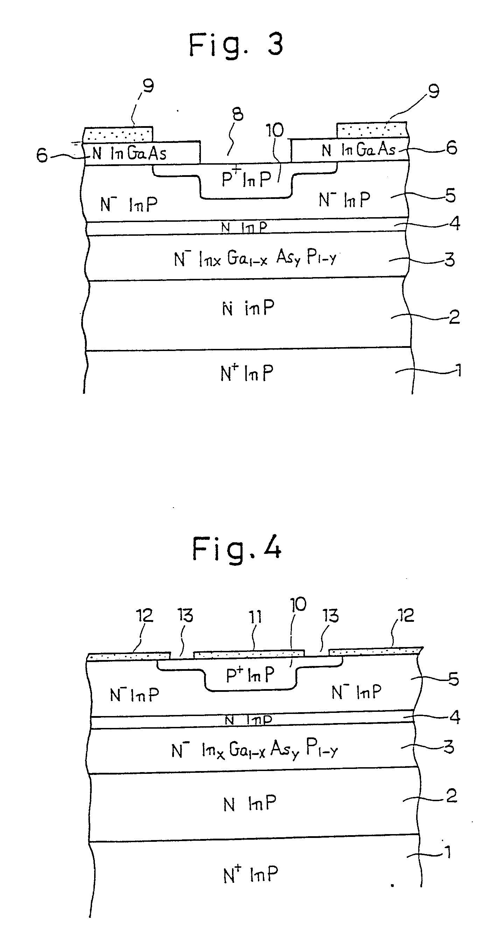

A fifth step is to grow an $n\text{-}In_xGa_{1-x}As$ layer (hereinafter referred to as a mask layer) 6 on the active layer 5. This mask layer 6 is intended to act as a mask during subsequent etching and diffusion steps for the final purpose of producing a step shaped p-n junction as shown in Figure 3. Therefore, an arbitrary magnitude of n-type impurity concentration is allowed, save that it should not be such as to give rise to any adverse effect in relation to the impurity concentration of the active layer 5 during subsequent diffusion processes. As described earlier, the foregoing five steps are carried out in one process employing liquid phase epitaxy.

A sixth step is to produce a resist photomask 7, resistant to sulphuric acid based solvents, on the mask 6 except for a part thereof corresponding to the light sensitive region.

Referring to Figure 2, a seventh step is selectively to remove the portion of the mask layer 6 unmasked by the resist photomask 7. A convenient process for accomplishing this step is to soak the wafer in a solution containing three portions of sulphuric acid, one portion of hydrogen peroxide and one portion of water, because this solution does not dissolve InP, albeit it does dissolve $In_xGa_{1-x}As$.

An eighth step is to remove the resist photomask 7, before a silicon dioxide layer is grown on the wafer, more specifically on the mask layer 6 and partly on the active layer 5. Photolithography is employed to remove parts of the silicon dioxide layer from the regions corresponding to the light sensitive region and a guard ring region, in order to produce a mask 9 having an opening 8 on the light sensitive region and the guard ring region.

Referring to Figure 3, a ninth step is to employ an impurity diffusion process to introduce a p-type impurity into an upper portion 10 of the active layer 5 to a high concentration such as $10^{18}/cm^3$. Due to the stepped shape of the double-layered mask 9 and 6, a p-n junction itself of a stepped shape is produced. In other words, the depth of the p-n junction is much larger, in the light sensitive region than in the guard ring region. This impurity diffusion process can be carried out at a temperature of 500°C employing $CdP_2$ as the impurity source. In this embodiment of the present invention the p-n junction comprises a relatively deep part, produced at a depth of 1.5 micrometers, in the light sensitive region and a relatively shallow part which extends around the deep part and is produced at a depth of 0.5 micrometers in the area corresponding to the guard ring region.

Therefore, the deep part of the p-n junction is located 1 micrometer above the interface between the active layer 5 and the middle layer 4, and the relatively shallow part providing the guard ring is located 2 micrometers above the interface between the active layer 5 and the middle layer 4. A two hour period was required for the diffusion to form the stepped shape p-n junction.

An alternative process, as described below, can be employed for production of the stepped shape p-n junction. In this alternative process, a recess is produced by means of an etching process applied to an area corresponding to the light sensitive region of the top surface of the n-InP active layer 5, rather than producing a mask made of $SiO_2$ layer 9 and the n-$In_xGa_{1-x}As$ layer 6 as described above, before a p-type impurity is diffused in. This has the advantage of simplicity and in reduction in the number of heating processes required.

Referring to Figure 4, a tenth step is to remove the $SiO_2$ layer 9 and the n-$In_xGa_{1-x}As$ layer 6 both of which were employed in combination as a mask in the previous step, before producing an

SiO$_2$ film 11 on the light sensitive region, which film 11 is to act as an anti-reflection coating, and another $SiO_2$ film 12 on the guard ring region and the region surrounding the guard ring region, which film 12 is to act as an insulator. Such films 11 and 12 are separated from one another by an area 13 on which an anode of the APD is to be produced between the films 11 and 12. The removal of the layer 9 and the layer 6 can be readily carried out by soaking the wafer respectively in a solution containing fluoric acid and ammonium fluoride and a sulphuric acid based solvent. Chemical vapour deposition and photolithography are in combination employed for production of the films 11 and 12.

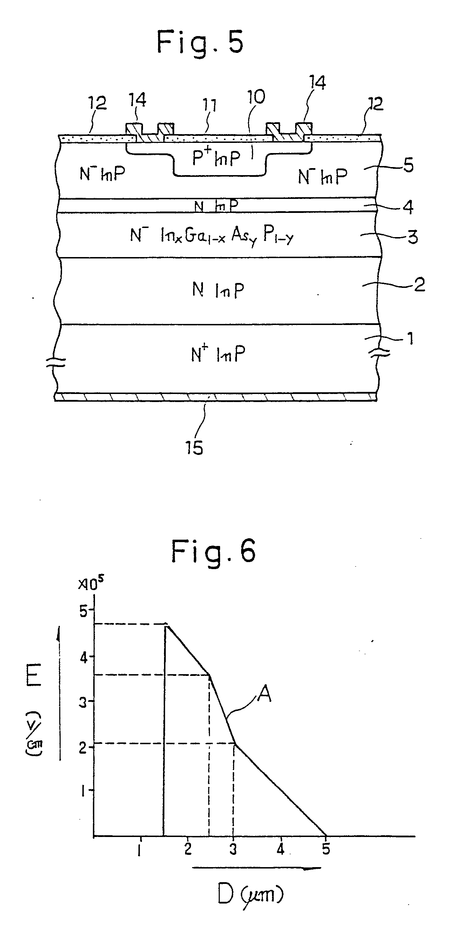

Referring to Figure 5, the eleventh step is to produce an anode 14 and a cathode 15 respectively on the area 13 and on the bottom surface of the wafer. In this case, the anode and the cathode are produced by means of the vacuum evaporation of AuZn and AuGe respectively.

When such an APD is operated, the APD has applied thereto a negative voltage and a positive voltave respectively at its anode and cathode. Since the application of these voltages reverse biases the p-n junction produced in an APD whose layer configuration is as shown by way of example in Figure 5, a depletion layer extends across the p-n junction.

Within a depletion layer, the differential of intensity of electric field versus the distance from a p-n junction is proportional to the impurity concentration of the corresponding region.

Therefore, in the case of a layer configuration as shown in Figure 5, the extent of the depletion layer is quite marginal towards the $p^+$ side of the p-n junction, the depletion layer tends to extend far into the middle layer 4 and the light absorbing layer 3.

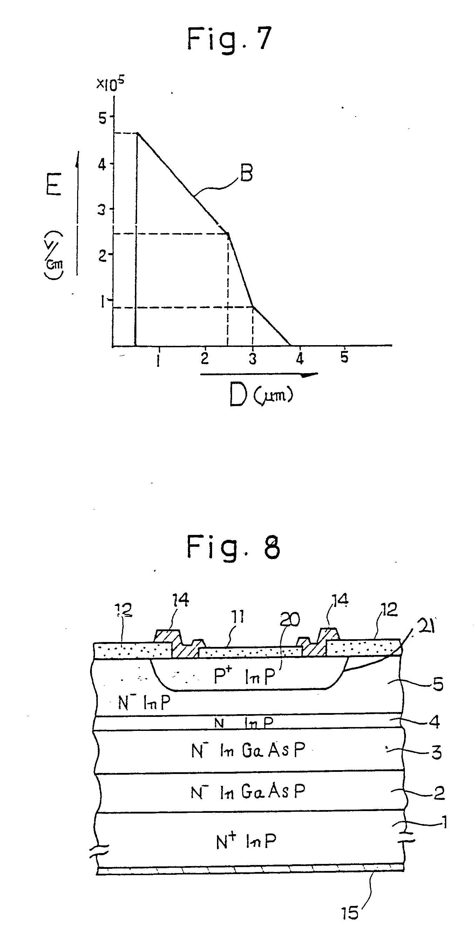

Since the p-n junction is step shaped and the impurity concentration is non-uniform in the direction of depth, the distance to which the depletion layer extends is different for the light sensitive region and for the region corresponding to the guard ring region. On the assumption that the n-type impurity concentration is $8 \times 10^{15}/cm^3$ for the active layer 5 and for the light absorbing layer 3 and is $2 \times 10^{16}/cm^3$ for the middle layer 4, the relationships between the intensity of electric field and depth from the wafer surface are as shown in the graphs of Figures 6 and 7.

The polygonal line A in the graph of Figure 6 illustrates the position in which a breakdown occurs in the light sensitive-region, whilst the polygonal line B in the graph of Figure 7 illustrates the position in which a breakdown occurs in the guard ring region.

From the graph of Figure 6 it will be seen that the intensities of electric field at the p-n junction, at the interface between the active layer 5 and the middle layer 4, and at the interface between the middle layer 4 and the light absorbing layer 3, are respectively $4.73 \times 10^5$ V/cm, $3,56 \times 10^5$ V/cm and $2.10 \times 10^5$ V/cm. In relation to the graph of Figure 7 it will be seen that the corresponding intensities of electric field are $4.73\times10^5$ V/cm, $2.39\times10^5$ V/cm and $0.93\times10^5$ V/cm respectively.

In each of the graphs of Figures 6 and 7, the area surrounded by the solid line, A or B, and the X-axis relates to breakdown voltage. Figure 6 shows that the breakdown voltage in the light sensitive region is 75.6 V. Figure 7 shows that the breakdown voltage in the area facing the guard ring is 90.2 V. Since a fairly large difference, specifically 14.6 V, is manifest between the breakdown voltages for the light sensitive region and for the area facing the guard ring, an APD in accordance with an embodiment of this invention allows breakdown to occur only in the light sensitive region, by virtue of the pronounced difference in breakdown voltages between the light sensitive region and the area facing the guard ring.

As described above, the middle layer 4 interleaved between the active layer 5 and the light absorbing layer 3 has a relatively large band gap and contains impurities in a relatively high concentration. This middle layer 4 causes a large decrease in electric field intensity, thereby decreasing the intensity of electric field in the light absorbing layer 3. This causes a reduction in the amount of tunnel current which may flow across this layer.

In an embodiment of the present invention in which the intensities of electric field are as described above, a maximum tunnel current accompanying a breakdown occurring in response to exposure to light having a wavelength of 1.35 micrometers, or the fundamental absorption edge of

$$In_xGa_{1-x}As_yP_{1-y},$$

is $8\times10^{-14}$ A, on the assumption that the diameter of a light window is 100 micrometers. Corresponding amount in a case in which the APD is exposed to light having a wavelength of 1.65 micrometers is $3\times10^{-8}$ A. Since the magnitude of tunnel current is much less than the magnitudes of dark current caused by other parameters, the magnitude of the overall dark current is satisfactorily decreased.

It is well known that the excess noise coefficient decreases in accordance with the ratio of ionisation factors of holes and electrons. On the other hand, it is also well known that the ionisation factors of holes and electrons increase in accordance with the inverse of electric field intensity. In the described embodiment of the present invention, therefore, the impurity concentration of the active layer 5 is decreased in order to decrease the intensity of electric field in the event of breakdown and, therefore, to increase the ratio of ionisation factors of holes and electrons. Thereby, the magnitude of excess noise is decreased.

From Figure 5, it will be readily appreciated that an APD in accordance with this embodiment of the present invention is of the planar type.

As described above, an APD embodying the present invention has a structure such as substantially to eliminate the above-mentioned tunnel current problem and which also provides a more pronounced difference in breakdown voltages.

In such an embodiment of the present invention the p-n junction has a stepped configuration, a relatively shallow part of the p-n junction surrounding a relatively deep part of the p-n junction, with an abrupt transition between the relatively deep and relatively shallow parts. The abrupt transitional part of the p-n junction may conform to a substantially vertical surface.

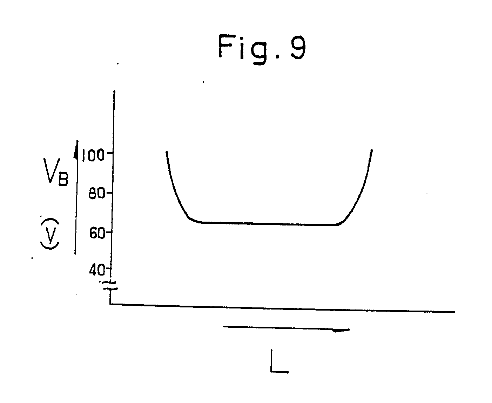

With reference to Figures 8 and 9 of the accompanying drawings, an APD in accordance with the first general embodiment of the present invention will now be described. As indicated in Figure 8, which shows the layer configuration of the APD, layer configuration in accordance with this first embodiment resembles fairly closely the layer configuration in accordance with the second general embodiment. The major difference resides in the fact that the p-n junction is not stepped shape but has inclined side parts which surround the light sensitive region. The p-n junction is in the neighbourhood of the interface between the middle layer and the active layer.

In other words, the $p^+$-InP region 20 in Figure 8 is not surrounded by a shallow guard ring region but rather has or is surrounded by gradually inclined sides.

In this case, the principle whereby the guard ring effect is realised is that the combination of such a p-n junction having a gradually inclined side and the middle layer 4 interleaved between the active layer 5 and the light absorbing layer 3 causes the breakdown voltage to be higher for a point remote from the edge of the side and the bottom of the p-n junction, thereby allowing the side of the p-n junction to act as a guard ring.

Specifically referring to Figure 8, the various parameters for substrate 1, buffer layer 2, the light absorbing layer 3 and active layer 5 are identical to those of the APD described above in connection with Figures 1 to 5.

The n-InP middle layer 4 has a thickness of 1 micrometer and an impurity concentration of $1\times10^{16}$/cm³. The depth of the $p^+$-InP region 20 is 1.5 micrometers. The other parameters, including those relating to the $SiO_2$ anti-reflection coating 11, the $SiO_2$ insulator film 12, the anode 14, and the cathode 15, are identical to those of the APD described in connection with Figures 1 to 5. The gradually inclined region 21 shown in Figure 8 may be formed, for example, by beryllium ion implantation.

The graph of Figure 9 illustrates the distribution of breakdown voltage along the top surface of the APD. The breakdown voltage 66.5 V within the light sensitive region, gradually increasing to 99.4 V at the external edge of the p-n junction, thereby realising a guard ring effect.

Albeit that in this case a less pronounced difference between breakdown voltage in the region facing the light window and in the guard ring region is realised than in an APD in accordance with the second general embodiment of the present invention, an APD as illustrated in Figure 8, in accordance with the first general embodiment of this invention, is operative from a practical point of view. Furthermore, the following additional advantages are provided:—

1. No mask is required for the production of a shallow part of the p⁺-InP region, because the APD has no such shallow part.
2. None of the adverse effects which can be caused by the use of a stepped shape p-n junction occur. In other words, with a step shape p-n junction, parts of the junction have only a small radius of curvature, or curve rather sharply, and a reduction in breakdown voltage is manifest at such sharp curves. With the configuration as illustrated in Figure 8 such adverse effects are not observed.

Of course, an APD in accordance with the first general embodiment of this invention, for example as illustrated in Figure 8, also provides for a reduced magnitude of dark current and lesser excess noise.

An APD of a form which is a modification of that illustrated in Figure 8 may be provided. In this modified form a low concentration p-type guard ring region is associated with the periphery of the light sensitive region, to provide the guard ring effect. Such a low concentration guard ring region may be formed by, for example, ion implantation of a p-type impurity, for example beryllium.

Thus, in one embodiment of the present invention a middle layer is provided between a light absorbing layer and an active layer, and a light sensitive region is provided which is separated from other regions of the active layer by a p-n junction having a gradually inclined side thereof surrounding the light sensitive region.

In another embodiment of the present invention a light sensitive region is separated from other regions of the active layer by a step shaped p-n junction having a deep area which faces the light sensitive region and shallow area which continuously extends, passing through an abruptly vertical side, from the deep area to surround the deep area.

In the embodiment of the present invention in which a light sensitive region is separated from other regions of the active layer by a p-n junction having a gradually inclined side, the inclined side of the p-n junction is so curved, gradually curved as, to avoid small radiuses of curvature and sharply curving features.

By the disposition of different parts of the p-n junction and by the layer configuration provided in accordance with the present invention tunnel current is reduced in an APD embodying the present invention as compared with previous APD's.

An embodiment of the present invention provides an avalanche photodiode, sensitive to light in the wavelength range 1.2 to 1.65 micrometers, which has a light absorbing layer, a middle layer and an active layer grown on a substrate in that order. All the layers contain impurities of the same conductivity type but impurity concentration is higher in the middle layer than in either the light absorbing layer or the active layer. A p-n junction having a flat bottom and either a gradually inclined side or a step shaped side is produced in the active layer, whereby the breakdown voltage is less in the area facing the flat bottom of the p-n junction than in the area facing such a side as has the aforementioned irregular shape, resultantly allowing the side to act as a guard ring without a large amount of tunnel current flowing through the light absorbing layer in response to the intensity of electric field.

## Claims

1. A planar type avalanche photodiode comprising:—
   a light absorbing layer (3) of a semiconductor containing at least one impurity of one conductivity type,
   a middle layer (4) of a semiconductor providing lattice matching between itself and the light absorbing layer (3) and having a larger band gap than that of the semiconductor of the light absorbing layer (3), the middle layer (4) being formed on the light absorbing layer, and containing at least one impurity of the said one conductivity type, and
   an active layer (5) of a semiconductor providing lattice matching between itself and the middle layer (4), having a larger band gap than the semiconductor of the light absorbing layer (3), the active layer (5) being formed on the middle layer (4) and primarily containing at least one impurity of the said one conductivity type, in a concentration less than that of the middle layer (4),
   a light sensitive region (10, 20) in the active layer which contains at least one impurity of a conductivity type opposite to the said one conductivity type which is separated from other regions of the active layer (5) by a p-n junction.

2. An avalanche photodiode as claimed in claim 1, wherein the said p-n junction has a relatively deep central part and gradually inclined parts (21), becoming gradually shallower, around the said central part.

3. An avalanche photodiode as claimed in claim 1, wherein the said p-n junction is a step shaped p-n junction having a relatively deep central part,
   a relatively shallow part which surrounds the relatively deep part, and an abrupt transitional part between the relatively deep and relatively shallow parts.

4. An avalanche photodiode as claimed in any preceding claim, the photodiode being sensitive to light in the wavelength range 1.2 micrometers to 1.65 micrometers.

5. An avalanche photodiode as claimed in any preceding claim, wherein the light absorbing layer (3), the middle layer (4) and the active layer (5) are of respective group III—V compound or alloy semiconductors.

6. An avalanche photodiode as claimed in claim 6, wherein the light absorbing layer (3) is of

$$In_xGa_{1-x}As_yP_{1-y}$$

the active layer (5) and the middle layer (4) are of InP.

7. An avalanche photodiode as claimed in claim 6, wherein the light absorbing layer (3) is of GaSb and the active layer (5) is of $Ga_xAl_{1-x}Sb$.

## Patentansprüche

1. Lawinenphotodiode vom planaren Typ mit:—

einer lichtabsorbierenden Schicht (3) aus einem Halbleiter, der wenigstens eine Verunreinigung von einem Leitfähigkeitstyp enthält,

einer mittleren Schicht (4) von einem Halbleiter, der eine Gitteranpassung zwischen sich selber und der lichtabsorbierenden Schicht (3) aufweist und eine Bandlücke hat, die größer als diejenige des Halbleiters der lichtabsorbierenden Schicht (3) ist, wobei die mittlere Schicht (4) auf der lichtabsorbierenden Schicht (3) gebildet ist und wenigstens eine Verunreinigung von dem genannten einen Leitfähigkeitstyp umfaßt, und

einer aktiven Schicht (5) aus einem Halbleiter, welcher eine Gitteranpassung zwischen sich selbst und der mittleren Schicht (4) aufweist und eine Bandlücke hat, die größer als diejenige des Halbleiters der lichtabsorbierenden Schicht (3) ist, wobei die aktive Schicht (5) auf der mittleren Schicht (4) gebildet ist und primär wenigstens eine Verunreinigung von dem genannten einen Leitfähigkeitstyp umfaßt, in einer Konzentration, die kleiner als diejenige der mittleren Schicht (4) ist, und einen lichtempfindlichen Bereich (10, 20) in der aktiven Schicht, der wenigstens eine Verunreinigung von einem Leitfähigkeitstyp umfaßt, der entgegengesetzt zu dem genannten einen Leitfähigkeitstyp ist, welcher von anderen Bereichen der aktiven Schicht (5) durch eine pn-Grenzschicht getrennt ist.

2. Lawinenphotodiode nach Anspruch 1, bei der die genannte pn-Grenzschicht einen relativ tiefen zentralen Abschnitt und, um den genannten zentralen Abschnitt, graduierlich geneigte Abschnitte (21) hat, die graduierlich flacher werden.

3. Lawinenphotodiode nach Anspruch 1, bei der die genannte pn-Grenzschicht eine stufenförmige pn-Grenzschicht ist, die einen relativ tiefen zentralen Abschnitt,

einen relativ flachen Abschnitt, der den relativ tiefen Abschnitt umgibt, und einen abrupten Übergangsteil zwischen den relativ tiefen und relativ flachen Abschnitten hat.

4. Lawinenphotodiode nach einem der vorhergehenden Ansprüche, bei der die Photodiode in dem Wellenlängenbeich von 1,2 Micrometer bis 1,65 Micrometer lichtempfindlich ist.

5. Lawinenphotodiode nach einem der vorhergehenden Ansprüche, bei der die lichtabsorbierende Schicht (3), die mittlere Schicht (4) und die aktive Schicht (5) aus jeweiligen Gruppen-III-V-Verbindungen oder Legierungshalbleitern bestehen.

6. Lawinenphotodiode nach Anspruch 5, bei der die lichtabsorbierende Schicht (3) aus

$$In_xGa_{1-x}As_yP_{1-y}$$

und die aktive Schicht (5) und die mittlere Schicht (4) aus InP bestehen.

7. Lawinenphotodiode nach Anspruch 6, bei der die lichtabsorbierende Schicht (3) aus GaSb und die aktive Schicht (5) aus $Ga_xAl_{1-x}Sb$ bestehen.

## Revendications

1. Photodiode à avalanche de type planar comprenant:

une couche absorbant la lumière (3) en un semiconducteur contenant au moins une impureté d'un premier type de conductivité,

une couche médiane (4) d'un semiconducteur assurant un accord de maille entre elle-même et la couche absorbant la lumière (3) et présentant un intervalle de bande plus grand que celui du semiconducteur de la couche absorbant la lumière (3), la couche médiane (4) étant formée sur la couche absorbant la lumière et contenant au moins une impureté du premier type de conductivité, et

une couche active (5) en un semiconducteur assurant un accord de maille entre lui-même et la couche médiane (4), ayant un intervalle de bande plus grand que le semiconducteur de la couche absorbant la lumière (3), la couche active (5) étant formée sur la couche médiane (4) et contenant essentiellement au moins une impureté du premier type de conductivité, selon une concentration moindre que celle de la couche médiane (4),

une région sensible à la lumière (10, 20) dans la couche active qui contient au moins une impureté du type de conductivité opposé au premier type de conductivité, et qui est séparée des autres régions dans la couche active (5) par une jonction p-n.

2. Photodiode à avalanche selon la revendication 1, dans laquelle la jonction p-n a une partie centrale relativement profonde et des parties inclinées progressivement (21), devenant progressivement moins profondes, autour de la partie centrale.

3. Photodiode à avalanche selon la revendication 1, dans laquelle la jonction p-n est une jonction p-n en forme de marche comprenant une partie centrale relativement profonde, une partie relativement peu profonde qui entoure la partie relativement profonde, et une partie de transition abrupte entre les parties relativement profonde et relativement peu profonde.

4. Photodiode à avalanche selon l'une quelconque des revendications précédentes, la photodiode étant sensible à de la lumière dans la gamme de longueurs d'ondes allant de 1,2 micromètres à 1,65 micromètres.

5. Photodiode à avalanche selon l'une quelconque des revendications précédentes, dans laquelle la couche absorbant la lumière (3), la couche médiane (4) et la couche active (5) sont constituées de semiconducteurs composés ou alliés du groupe III—V.

6. Photodiode à avalanche selon la revendication 5, dans laquelle la couche absorbant la lumière (3) est constituée de

$$In_xGa_{1-x}As_yP_{1-y},$$

la couche active (5) et la couche médiane (4) sont constituées d'InP.

7. Photodiode à avalanche selon la revendication 6, dans laquelle la couche absorbant la lumière (3) est constituée de GaSb et la couche active (5) de $Ga_xAl_{1-x}Sb$.

# Fig.1

| | |
|---|---|
| 7 | |
| N $In_xGa_{1-x}As$ | 6 |
| $N^-$ $InP$ | 5 |
| N $InP$ | 4 |
| $N^-$ $In_xGa_{1-x}As_yP_{1-y}$ | 3 |
| N $InP$ | 2 |
| $N^+$ $InP$ | 1 |

# Fig. 2

| | | |
|---|---|---|
| 9 | 8 | 9 |
| N $InGaAs$ | | N $InGaAs$ |
| 6 | | 6 |
| $N^-$ $InP$ | | 5 |
| N $InP$ | | 4 |
| $N^-$ $In_xGa_{1-x}As_yP_{1-y}$ | | 3 |
| N $InP$ | | 2 |
| $N^+$ $InP$ | | 1 |

# Fig. 3

# Fig. 4

# Fig. 5

# Fig. 6

# Fig. 7

# Fig. 8

# Fig.9